# EUROPEAN PATENT APPLICATION

(11) **EP 4 571 822 A1**
(43) Date of publication of application: **18.06.2025**
(21) Application number: 24218595.7
(22) Date of filing: 10.12.2024
(51) Int. Cl.: H01L 21/67, C23C 16/44

(54) **HIGH PRESSURE SUBSTRATE PROCESSING APPARATUS**

(30) Priority: 12.12.2023 US 202318536583
(71) Applicant: HPSP Co., Ltd., Hwaseong-si, Gyeonggi-do 18449 (KR)
(72) Inventor: COTO, Jose Salvador, 456 Oakmead Parkway, Sunnyvale, CA 94085 (US); RIVERA, Manuel Scott, 456 Oakmead Parkway, Sunnyvale, CA 94085 (US); NGUYEN, Loc Huu, 456 Oakmead Parkway, Sunnyvale, CA 94085 (US)
(74) Representative: von Bülow & Tamada

(57) **Abstract**

Provided is a high pressure substrate processing apparatus including: an inner chamber accommodating a substrate to be processed and a reaction gas supplied at a first pressure higher than an atmospheric pressure; an outer chamber including an external housing accommodating the inner chamber, and an external door movable between a closed state where the external housing is closed and an opened state where the external housing is opened, and accommodating a protective gas supplied at a second pressure set with respect to the first pressure; a fastening module configured to fasten the external housing with the external door in the closed state; and a capture module disposed to be adjacent to a contact position between the external housing and the external door for their fastening, and configured to capture a foreign material.

## Description

### BACKGROUND

### Field

The present disclosure relates to an apparatus used for processing a substrate at a high pressure.

### Description of the Related Art

In general, various processing may be performed on a semiconductor wafer during a manufacturing process of a semiconductor device. An example of the processing may include oxidation, nitriding, deposition, ion implantation, or the like. The example may also include a hydrogen or deuterium heat treatment process to improve an interface property of the semiconductor device.

A gas used for the processing may be supplied to a chamber at a high pressure and act on the semiconductor wafer. It is necessary for the housing and door of the chamber to be firmly fastened with each other to maintain the high pressure in the chamber.

During a fastening process between the housing and the door, friction may occur due to their relative movements. The friction may form a foreign material, and the foreign material may contaminate the wafer.

The above-mentioned background describes technical information possessed for deriving embodiments of the present disclosure or acquired during a derivation process, by an inventor, and cannot necessarily be considered as known technology disclosed to the general public before this application.

### SUMMARY

An object of the present disclosure is to provide a high pressure substrate processing apparatus with a minimum possibility that a foreign material contaminates a substrate during a fastening process of a chamber.

According to an embodiment of the present disclosure, a high pressure substrate processing apparatus includes: an inner chamber accommodating a substrate to be processed and a reaction gas supplied at a first pressure higher than an atmospheric pressure; an outer chamber including an external housing accommodating at least a part of the inner chamber, and an external door movable between a closed state where the external housing is closed and an opened state where the external housing is opened, and accommodating a protective gas supplied at a second pressure set with respect to the first pressure; a fastening module configured to fasten the external housing with the external door in the closed state; and a capture module disposed to be adjacent to a contact position between the external housing and the external door for their fastening, and configured to capture a foreign material.

The fastening module may include a support protrusion connected to the external housing, and a locking protrusion connected to the external door and supported by the support protrusion by transition from a first relationship where the locking protrusion is offset from the support protrusion to a second relationship where the locking protrusion corresponds to the support protrusion, the foreign material may include a metal particle formed by contact between the support protrusion and the locking protrusion during the transition from the first relationship to the second relationship, and the capture module may include a magnetic force unit configured to generate a magnetic force to adsorb the metal particle.

The magnetic force unit may be installed in one of the external housing and the external door.

The fastening module may further include a rotating member from which the support protrusion protrudes, and the magnetic force unit may be installed in the external housing through the rotating member.

The rotating member may include a rotating ring rotatably mounted on the external housing, and the magnetic force unit may be attached to at least one of the support protrusion and the rotating ring.

The magnetic force unit may include a magnet, and a coating layer covering the magnet to prevent oxidation of the magnet.

The coating layer may include at least one of nickel, magnesium, titanium, tungsten, and chromium as its coating material.

The magnetic force unit may include a plurality of magnets forming a circular arrangement around a central axis of the external door.

The plurality of magnets may be classified into a plurality of groups based on a distance by which the magnet is spaced apart from the central axis.

According to another embodiment of the present disclosure, a high pressure substrate processing apparatus includes: a chamber including a housing, and a door opening and closing the housing; a fastening module configured to fasten the housing with the door to maintain a process gas injected into the chamber at a pressure higher than an atmospheric pressure; and a capture module disposed to be adjacent to a contact position between the housing and the door for their fastening, and configured to capture a metal particle, wherein the capture module includes a magnetic force unit including a magnet adsorbing the metal particle.

The fastening module may include a support protrusion connected to the housing, and a locking protrusion connected to the door, and supported by the support protrusion by transition from a first relationship where the locking protrusion is offset from the support protrusion to a second relationship where the locking protrusion corresponds to the support protrusion, and the metal particle may be formed by contact between the support protrusion and the locking protrusion while the support protrusion performs a relative rotation with respect to the locking protrusion for the transition from the first relationship to the second relationship.

The plurality of magnets may form a circular arrangement around a central axis of the door.

The magnetic force unit may include a coating layer coated on the magnet with at least one material selected from nickel, magnesium, titanium, tungsten, and chromium.

The process gas may include a reaction gas which includes an active gas and a protective gas which is an inert gas, the housing may include an inner housing formed to accommodate a substrate to be processed and the reaction gas, and an external housing accommodating at least a part of the inner housing and coupled to the inner housing to form a closed space for accommodating the protective gas together with the inner housing, and the door may be formed to close the inner housing.

The fastening module may include a support protrusion connected to the external housing, and a locking protrusion connected to the door and transitioned from a first relationship where the locking protrusion is offset from the support protrusion to a second relationship where the locking protrusion is supported by the support protrusion as the door is rotated, and the magnetic force unit may be configured to collect a foreign material formed by contact between the support protrusion and the locking protrusion during the transition from the first relationship to the second relationship.

### BRIEF DESCRIPTION OF THE DRAWINGS

FIG. 1 is a conceptual view of a high pressure substrate processing apparatus 100 according to an embodiment of the present disclosure.
FIG. 2 is a perspective view showing an opened state where an external housing 121 is opened by an external door 125 in the high pressure substrate processing apparatus 100 of FIG. 1.
FIG. 3 is a cross-sectional view showing a relationship between a support protrusion 153 and a locking protrusion 155 when implementing a closed state where the external housing 121 is closed by the external door 125 in FIG. 2.
FIG. 4 is a partial perspective view showing a fastened state between the external housing 121 and external door 125 in the high pressure substrate processing apparatus 100 of FIG. 2.
FIGS. 5A to 5C are perspective views individually showing magnetic force units 171, 173, and 175 of FIG. 4.
FIG. 6 is a perspective view for explaining an arrangement of a capture module 170.

### DETAILED DESCRIPTION

Hereinafter, the present disclosure is described in detail with reference to the accompanying drawings.

The present disclosure is not limited to the embodiments described below, may be variously modified, and may be implemented in several forms. These embodiments are provided only to make the present disclosure complete and allow those skilled in the art to completely appreciate the scope of the present disclosure. Therefore, it is to be understood that the present disclosure is not limited to the embodiments disclosed below, includes substitution or addition of a configuration in one embodiment with or to a configuration in another embodiment, as well as all modifications, equivalents, or substitutions, included in the spirit and scope of the present disclosure.

Furthermore, it is to be understood that the accompanying drawings are provided only to allow the embodiments of the present disclosure to be easily understood, and the spirit of the present disclosure is not limited by the accompanying drawings, and includes all the modifications, equivalents and substitutions, included in the spirit and scope of the present disclosure. In consideration of convenience of understanding, the size or thickness of a component may be expressed as exaggeratedly large or small in the drawings, and the scope of the present disclosure should not be interpreted as being limited due to this expression.

Terms used in the specification are used only to describe the specific implementation examples or embodiments rather than limiting the present disclosure. In addition, a term of a singular number may include its plural number unless explicitly indicated otherwise in the context. Terms "include", "have", and the like used in the specification specify the presence of features, numerals, steps, operations, components, parts, or combinations thereof, mentioned in the specification. That is, it is to be understood that the term "include" or "have" does not preclude the presence or addition of one or more other features, numerals, operations, components, parts, or combinations thereof, which is mentioned in the specification.

Terms including ordinal numbers such as "first", "second", and the like may be used to describe various components. However, these components are not limited by these terms. The terms are used only to distinguish one component from another component.

It is to be understood that when one element is referred to as being "connected/communicated to" or "in contact with" another element, one element may be directly connected/communicated to or in direct contact with another element, or may be connected/communicated to or in contact with another element while having a third element interposed therebetween. On the other hand, it is to be understood that when one component is referred to as being "directly connected/communicated to" or "in direct contact with" another component, one component may be connected/communicated to or in contact with another component with no third component interposed therebetween.

It is to be understood that when an element is referred to as being "on" or "below" another element, the element may be "directly on" another element, or may have a third element interposed therebetween.

Unless defined otherwise, it is to be understood that all the terms including technical and scientific terms, used herein, have the same meanings as those that are generally understood by those skilled in the art to which the the present disclosure pertains. Terms generally used and defined by a dictionary should be interpreted as having the same meanings as meanings within a context of the related art, and should not be interpreted as having ideal or excessively formal meanings unless being clearly defined otherwise in the present application.

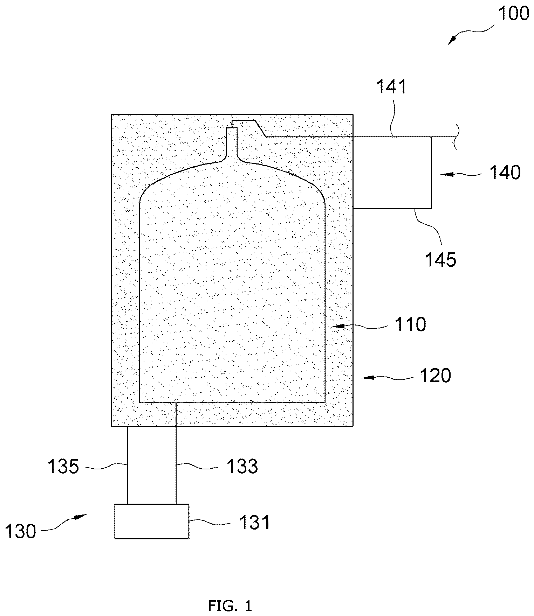

FIG. 1 is a conceptual view of a high pressure substrate processing apparatus 100 according to an embodiment of the present disclosure.

Referring to this drawing, the high pressure substrate processing apparatus 100 may include an inner chamber 110, an outer chamber 120, a gas supply module 130, and a gas exhaust module 140.

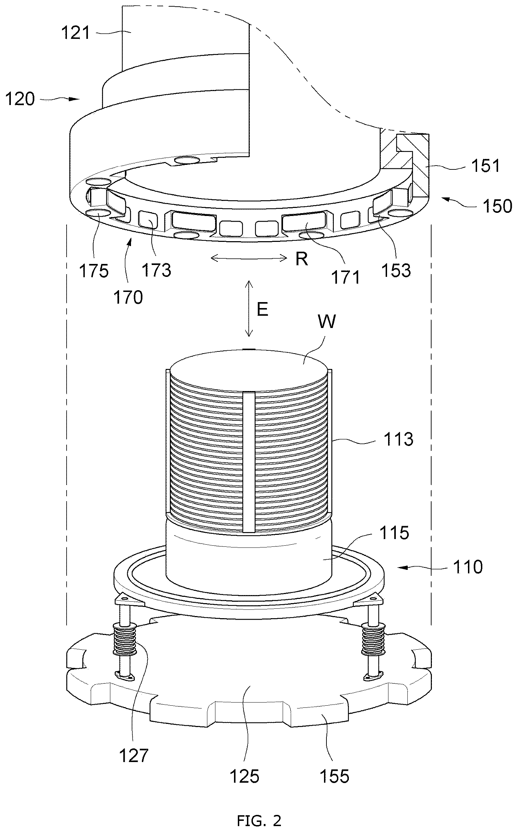

The inner chamber 110 may have a processing area for accommodating a substrate to be processed. The inner chamber 110 may be made of a non-metallic material, for example, quartz, to reduce a substrate contamination risk in a high pressure and high temperature working environment. As a heater (not shown) disposed outside the inner chamber 110 is operated, a temperature of the inner chamber 110 may reach hundreds to thousands of degrees Celsius. The substrate may be, for example, a semiconductor wafer W (see FIG. 2) mounted on a holder 113 (see FIG. 2). The substrate is not limited to the wafer, and may be any other base structure for making a circuit. For example, the substrate may also include glass for producing a display. The holder 113 may be a boat which may stack the substrates to be processed in a plurality of layers.

The outer chamber 120 is disposed to accommodate at least a part of the inner chamber 110. Unlike the inner chamber 110, the outer chamber 120 is free from the substrate contamination risk, and may thus be made of a metallic material. The outer chamber 120 may have a hollow protective area for accommodating the inner chamber 110.

The gas supply module 130 may be a component supplying a gas to the inner chamber 110 and the outer chamber 120. The gas supply module 130 may have a gas supplier 131 communicated with utility (or gas supply facility) of a semiconductor factory. The gas supplier 131 may selectively provide the inner chamber 110 with a reaction gas, for example, a hydrogen gas (H₂), a deuterium gas (D₂), a fluorine gas (F₂), an ammonia gas (NH₃), a chlorine gas (Cl₂), or a nitrogen gas (N₂). The gas supplier 131 may provide the outer chamber 120 with, for example, the nitrogen gas or an argon gas (Ar), which is an inert gas, as a protective gas. The reaction gas and the protective gas may each be injected into the internal chamber 110 or the external chamber 120 through a reaction gas line 133 or a protective gas line 135. In detail, the protective gas injected into the outer chamber 120 may be injected into a space (protective space) between the outer chamber 120 and the inner chamber 110. The reaction gas and the protective gas may simply be referred to as a process gas.

The process gas may be supplied to form a pressure higher than an atmospheric pressure (high pressure), for example, ranging from several atmospheres to tens of atmospheres, or more. When a pressure of the reaction gas in the internal chamber 110 is a first pressure, and a pressure of the protective gas in the external chamber 120 is a second pressure, these pressures may maintain a predetermined relationship (or range). For example, the second pressure may be set to be substantially equal to or slightly greater than the first pressure. Such a pressure relationship may prevent leakage of the reaction gas from the inner chamber 110 and breakage of the inner chamber 110. The second pressure may be set to be slightly lower than the first pressure, and a similar effect as before may be achieved even in that case.

The gas exhaust module 140 may be a component exhausting the process gas. A gas exhaust pipe 141 may be connected to an upper portion of the inner chamber 110. Similarly, a gas exhaust pipe 145 connected to the outer chamber 120 may be provided to exhaust the protective gas from the outer chamber 120. These gas exhaust pipes 141 and 145 may be communicated with each other, and the reaction gas may thus be diluted with the protective gas in its exhaust process to have a lower concentration.

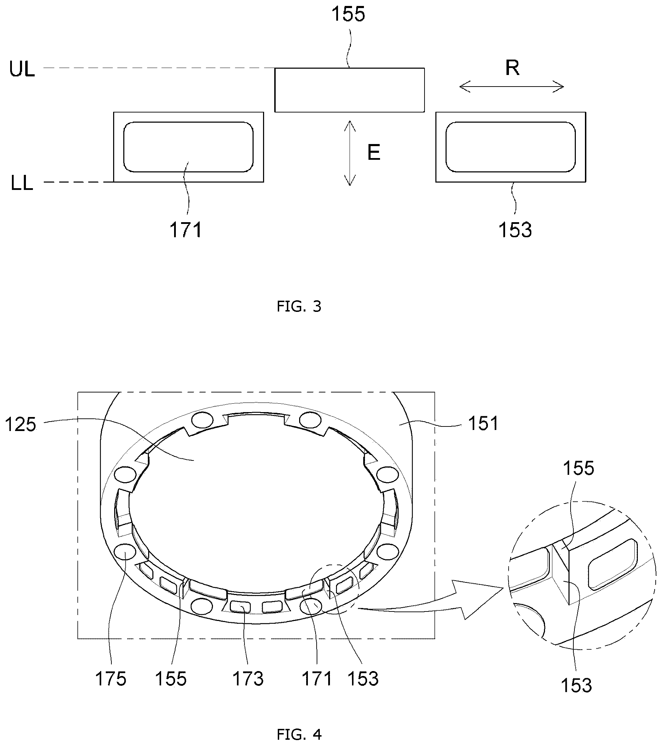

A fastening structure of the outer chamber 120 is described with reference to FIGS. 2 to 4. FIG. 2 is a perspective view showing an opened state where an external housing 121 is opened by an external door 125 in the high pressure substrate processing apparatus 100 of FIG. 1; FIG. 3 is a cross-sectional view showing a relationship between a support protrusion 153 and a locking protrusion 155 when implementing a closed state where the external housing 121 is closed by the external door 125 in FIG. 2; and FIG. 4 is a partial perspective view showing a fastened state between the external housing 121 and external door 125 in the high pressure substrate processing apparatus 100 of FIG. 2.

Referring to the drawings, the inner chamber 110 may include an inner housing (not shown) and an inner door 115. The inner housing may have a processing area for accommodating a substrate W, and its lower portion may be open. The inner housing may be mounted on the external housing 121 described below. The inner door 115 may close the open lower portion of the inner housing. The inner door 115 may have a shape of a trough generally open downward. As the inner door 115 descends in an opening/closing direction E, the processing area may be opened (or in the opened state, see FIG. 2). The opening/closing direction E may be the direction in which the inner door 115 gets closer to or further away from the inner housing. In the opened state, the substrate W may be loaded into the processing area or unloaded from the processing area. As the inner door 115 ascends in the opening/closing direction E, the inner door 115 may come into contact with the inner housing. In this case, the processing area may be closed (or in the closed state).

The outer chamber 120 may also include the external housing 121 and the external door 125. The external housing 121 may entirely accommodate the inner chamber 110. Accordingly, the external housing 121 may surround not only the inner housing but also the inner door 115. The external door 125 may also open and close the external housing 121 by its movement. The external door 125 may be connected to the inner door 115 by a support member 127 to thus support the inner door 115. In that case, the inner door 115 may open and close the inner housing while being moved in conjunction with the ascending and descending of the external door 125. The expressions "opened state" and "closed state" may also be applied to a relationship between the external housing 121 and the external door 125 as they are. Unlike the above, the inner door 115 may be opened and closed independently from the external door 125.

The high pressure substrate processing apparatus 100 may further include a fastening module 150 fastening the external housing 121 with the external door 125 in the closed state. The fastening module 150 may allow the protective gas to maintain the second pressure in the outer chamber 120. In a case where the inner door 115 is supported on the external door 125 by the support member 127, the fastening module 150 may also fasten the inner door 115 to the inner housing. As a result, the fastening module 150 may allow the reaction gas to maintain the first pressure in the inner chamber 110.

In detail, the fastening module 150 may include a rotating member 151, the support protrusion 153, and the locking protrusion 155.

The rotating member 151 may be a component rotatably connected to the external housing 121 or the external door 125. In this embodiment, the rotating member 151 may be a rotating ring mounted on the external housing 121. The rotating ring 151 may be disposed to surround an outer peripheral surface of the external housing 121, and may be rotated around a central axis of the external housing 121. A force for rotating the rotating ring 151 may be provided from a driving wheel (not shown) engaged with the rotating ring 151. The rotating ring 151 may form a second plane parallel to a first plane formed by the support protrusion 153 or the locking protrusion 155, which are described below. Each of the first and second planes may be a plane generally perpendicular to the opening/closing direction E.

The support protrusion 153 may be a protrusion connected to the external housing 121. In detail, the support protrusion 153 may be connected to the external housing 121 through the rotating ring 151. The support protrusion 153 may protrude from an inner peripheral surface of the rotating ring 151, for example. The plurality of support protrusions 153 may be arranged in a circumferential direction of the rotating ring 151.

The locking protrusion 155 may be a protrusion connected to the external door 125. For example, the locking protrusion 155 may protrude from an outer peripheral surface of the external door 125. When the external door 125 ascends in the opening/closing direction E, the locking protrusion 155 may have a size in which the locking protrusion 155 passes between the pair of adjacent support protrusions 153. The locking protrusion 155 may be disposed at a higher level than the support protrusion 153 in the closed state (see FIG. 3). As the support protrusion 153 is rotated in a rotation direction R, the locking protrusion 155 may be disposed on the support protrusion 153, and supported by the support protrusion 153 (or in the fastened state, see FIG. 4). A level of the external door 125 in the fastened state may be substantially the same as that in the closed state. The fastened state may be understood as one of the closed states.

The closed state may be achieved when the external door 125 ascends in the opening/closing direction E while the locking protrusion 155 is disposed to be offset from the support protrusion 153 (or in a first relationship, see FIG. 3). In the closed state, as the rotating ring 151 is rotated in the rotation direction R, the support protrusion 153 may be rotated with respect to the locking protrusion 155. An upper surface of the support protrusion 153 may be rotated while being in contact with a lower surface of the locking protrusion 155. By its rotation, the supporting protrusion 153 may be disposed to correspond to the locking protrusion 155 (or in a second relationship, see FIG. 4).

A foreign material may be formed by a fastening operation (in detail, the rotation of the rotating ring 151 for transition from the first relationship to the second relationship (or vice versa)) of the fastening module 150 or the like. The high pressure substrate processing apparatus 100 may further include a capture module 170 capturing the foreign material.

The foreign material may be a particle formed by the contact between the support protrusion 153 and the locking protrusion 155, or a particle floating around the support protrusion 153 and the locking protrusion 155 due to a cause other than the contact. The former particle may be formed by friction between the upper surface of the support protrusion 153 and the lower surface of the locking protrusion 155. The capture module 170 may be an electric force unit capturing the foreign material by using a force acting between electric charges. For example, the electric force unit may be one (an electrostatic filter) in which positive and negative charges are separated from each other to form static electricity as an ultra-high voltage current is applied to a nonwoven fabric. Unlike the above, the capture module 170 may include a tape with an adhesive component. The electric force unit and the adhesive tape may be installed at approximately the same location as an installation location of the magnetic force unit described below.

As the support protrusion 153 and/or the locking protrusion 155 are made of a metal, the particle may mainly have a metal component. Accordingly, the capture module 170 may include the magnetic force unit generating a magnetic force to adsorb the metal particle.

The magnetic force unit may be installed on the rotating ring 151. As the rotating ring 151 is mounted on the external housing 121, the magnetic force unit may be installed in the external housing 121 as a result. This arrangement may be distinguishable from the configuration that the magnetic force unit is installed on the external door 125.

For example, the magnetic force units may be classified into a first magnetic force unit 171, a second magnetic force unit 173, and a third magnetic force unit 175. The magnetic force units 171, 173, and 175 may each be provided as the plurality of magnetic force units. The first magnetic force units 171 to the third magnetic force units 175 may each be grouped based on their arrangement location, shape, etc. In detail, when the first magnetic force unit 171 is attached to the support protrusion 153, the second magnetic force unit 173 may be attached to a space between the pair of adjacent support protrusions 153 on the inner peripheral surface of the rotating ring 151. On the other hand, the third magnetic force unit 175 may be attached to a bottom surface of the rotating ring 151. The first magnetic force unit 171 and the second magnetic force unit 173 may be disposed in a space defined by an inner surface of the external housing 121. The third magnetic force unit 175 may be disposed in a space defined by an outer surface of the external housing 121. The first magnetic force unit 171 to the third magnetic force unit 175 may all be adopted, or only one or two of the magnetic force units may be adopted. Among the magnetic force units 171, 173, and 175, one magnetic force unit may be provided rather than the plurality of magnetic force units of one type.

The first magnetic force unit 171 to the third magnetic force unit 175 may be disposed to be adjacent to a contact position between the support protrusion 153 and the locking protrusion 155. For example, the magnetic force units 171, 173, and 175 may be generally disposed between an upper boundary UL corresponding to the upper surface of the locking protrusion 155 and a lower boundary LL corresponding to the lower surface of the support protrusion 153 along the opening/closing direction E (see FIG. 3). Alternatively, the upper boundary UL may be set as high as a thickness of the locking protrusion 155 or several times higher than the corresponding thickenss, and the lower boundary LL may be set as low as a thickness of the support protrusion 153 or several times lower than the corresponding thickenss. Furthermore, the magnetic force units 171, 173, and 175 may be disposed at a lower height than the contact position. This arrangement may be advantageous for the magnetic force units 171, 173, and 175 to capture the metal particles descending from the contact position.

In an alternative embodiment, the magnetic force unit may be directly installed on the external door 125, or may be installed on the external door 125 through the locking protrusion 155. For example, the magnetic force unit may be disposed on a side surface of the locking protrusion 155 or between the pair of adjacent locking protrusions 155. The magnetic force units may also be attached to the plurality of outer surfaces of the external door 125. In detail, the magnetic force units may be attached to the side and bottom surfaces of the external door 125.

In the above embodiments, the magnetic force unit may be disposed outside a closed space defined by the external housing 121 and the external door 125. The closed space may be a space where the process gas, specifically, the protective gas, is injected.

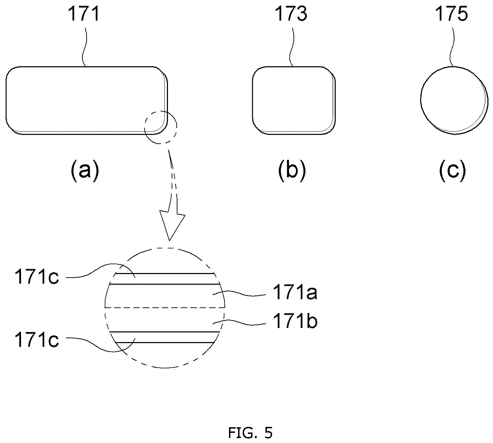

FIGS. 5A to 5C are perspective views individually showing the magnetic force units 171, 173, and 175 of FIG. 4.

Referring to this drawing, each of the first magnetic force unit 171 to the third magnetic force unit 175 may have a shape and a size which correspond to an area to which the magnetic force unit is attached. In this embodiment, each of the first magnetic force unit 171 and the second magnetic force unit 173 may be generally rectangular, and the third magnetic force unit 175 may be generally circular. Each of the magnetic force units 171, 173, and 175 is not limited to an exemplified shape (or size), and may have another shape. For example, the third magnetic force unit 175 may have a ring shape or a curved shape corresponding to the bottom surface of the rotating ring 151. It may be advantageous for each of the magnetic force units 171, 173, and 175 to capture the metal particle when having a main surface area which is as large as an installation target allows.

Basic structures of the magnetic force units 171, 173, and 175 are the same as each other, and the description is to be provided based on the first magnetic force unit 171. The first magnetic force unit 171 may have a magnet generating the magnetic force. The magnet may be a neodymium magnet. When a north (N) pole 171a of the magnet occupies a front portion, a south (S) pole 171b of the magnet may occupy a back portion. Here, each of the front portion and the back portion may be a region corresponding to a main surface of the magnet. A display part (not shown) indicating a polarity of the magnet may be formed on the front portion. The display part may be a marker for indicating the N pole 171a, and may be, for example, a dot or a character (e.g., 'N'), which is formed on the front portion. The dot or the character may be printed, embossed, or engraved on the front portion.

An outer surface of the magnet may be covered with a coating layer 171c. The coating layer 171c may be provided to prevent oxidation of the magnet. A coating material for forming the coating layer 171c may be, for example, selected from nickel, magnesium, titanium, tungsten, and chromium. The coating layer 171c may be an alloy of different materials among the coating materials. The coating layer 171c may also be a stack of single materials or a stack of alloys of the single materials, among the coating materials.

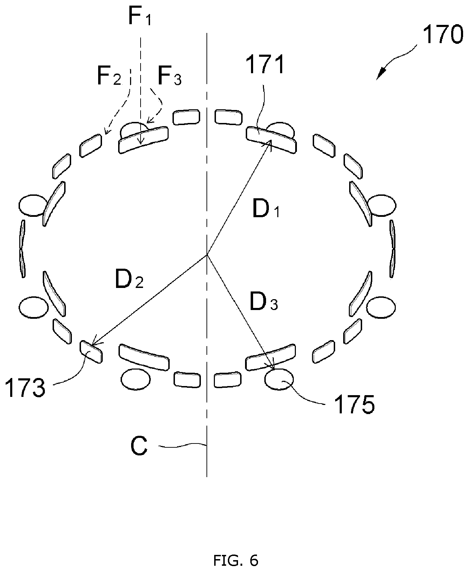

FIG. 6 is a perspective view for explaining an arrangement of the capture module 170.

Referring to this drawing, the plurality of magnetic force units 171, 173, and 175 may form a circular arrangement around a central axis C of the external door 125. The magnetic force units 171, 173, and 175 may be spaced apart from the central axis C by different distances. Each of the plurality of first magnetic force units 171 may be spaced apart from the central axis C by a first distance D1, and each of the plurality of second magnetic force units 173 may be spaced apart from the central axis C by a second distance D2. Each of the plurality of third magnetic force units 175 may be spaced apart from the central axis C by a third distance D3. The first distance D1 may be the shortest, the second distance D2 and the third distance D3 may be similar to each other.

The magnetic force units 171, 173, and 175 may be arranged to have the same magnetic pole disposed on each of their surfaces facing the central axis C. For example, the N poles may all be disposed on the main surfaces of the first magnetic force unit 171 and the second magnetic force unit 173 that face the central axis C. The N pole of the third magnetic force unit 175 may be disposed on its surface exposed to the outside.

By this arrangement, the first magnetic force unit 171 may most effectively adsorb the metal particle. The metal particle formed in a contact process between the locking protrusion 155 and the support protrusion 153 (see FIG. 4 above) may fall toward the nearest first magnetic force unit 171 (see F1), and the first magnetic force unit 171 may thus most effectively capture the metal particle. Some of the metal particles may fall on both sides of the support protrusion 153 (see F2), and the second magnetic force unit 173 may thus capture these metal particles. Further, when the external door 125 is moved in the opened state, a laminar flow may be formed from the inner space to the outside. This laminar flow may carry the metal particles not only to the inner peripheral surface of the rotating ring 151 but also to its bottom surface (see F3). The third magnetic force unit 175 may thus also capture some of the metal particles.

In an alternative embodiment, the rotating ring as the rotating member may be rotatably connected to the external door. When the support protrusion is formed in the external housing, the locking protrusion may be formed on the rotating ring. The capture module may be installed in the external housing, and may capture the particle formed by relative rotations of the locking protrusion and the support protrusion. The capture module may still be disposed outside the closed space defined by the external door and the external housing. On the other hand, the external door may be rotated in a state where the locking protrusion is connected to the external door. In this case, a tool, such as a bearing, which may block a rotational force of the external door from being transmitted to the inner door may be installed between the inner door and the external door. In this case, the substrate may not be rotated despite the rotation of the external door. The collection module may be installed in the external housing, the external door, or the like.

In another alternative embodiment, the locking protrusion 155 may be moved with respect to the support protrusion 153 in a manner other than the rotational motion, for example, by a translational motion. In that case as well, the metal particle formed during the transition from the first relationship to the second relationship may be captured by the capture module 170.

According to the high pressure substrate processing apparatus according to the present disclosure configured as above, the foreign material derived from the fastening operation of fastening the housing and door of the chamber for the high pressure processing of the substrate may be captured by the capture module. The foreign material resulting from the fastening operation may thus be removed before the foreign material affects the substrate. It is thus possible to minimize the possibility of the substrate contamination by the foreign material.

The specification exemplifies the processing apparatus having double chambers 110 and 120 as the high pressure substrate processing apparatus 100. However, the present disclosure is not limited thereto. A processing apparatus with a single chamber may also fall within the scope of the present disclosure. The single chamber may include one housing and one door. The substrate may be disposed in the chamber, and the process gas for processing the substrate, the reaction gas in detail, may be supplied to the chamber. The fastening module 150 and the capture module 170 may also be applied to this single chamber as they are. The configurations of the fastening module 150 and the collection module 170 may also be applied to a semi-dual chamber, which is an intermediate form between dual chamber and single chamber. The semi-dual chamber may have two housings (inner housing and external housing) and one door. The two housings may be coupled to each other by their own shapes or by having a separate member intervened therebetween to thus form a closed space (corresponding to the protective space). Similar to the previous embodiment, the substrate may be disposed in the processing chamber of the inner housing and the reaction gas may be injected into the processing chamber, and the protective gas may be injected into the closed space. Unlike the previous embodiments, the door may not be completely protected by the protective gas, and may be exposed to the outside. The door may correspond to the external door in the previous embodiment. The door may open and close the inner housing. The specification exemplifies a batch type processing apparatus, and the present disclosure is not limited thereto. The present disclosure may also be applied to a single wafer type processing apparatus as it is.

## Claims

1. A high pressure substrate processing apparatus comprising:
an inner chamber accommodating a substrate to be processed and a reaction gas supplied at a first pressure higher than an atmospheric pressure;
an outer chamber including an external housing accommodating at least a part of the inner chamber, and an external door movable between a closed state where the external housing is closed and an opened state where the external housing is opened, and accommodating a protective gas supplied at a second pressure set with respect to the first pressure;
a fastening module configured to fasten the external housing with the external door in the closed state; and
a capture module disposed to be adjacent to a contact position between the external housing and the external door for their fastening, and configured to capture a foreign material.

2. The apparatus of claim 1, wherein the fastening module includes
a support protrusion connected to the external housing, and
a locking protrusion connected to the external door and supported by the support protrusion by transition from a first relationship where the locking protrusion is offset from the support protrusion to a second relationship where the locking protrusion corresponds to the support protrusion,
the foreign material includes a metal particle formed by contact between the support protrusion and the locking protrusion during the transition from the first relationship to the second relationship, and
the capture module includes a magnetic force unit configured to generate a magnetic force to adsorb the metal particle.

3. The apparatus of claim 2, wherein the magnetic force unit is installed in one of the external housing and the external door.

4. The apparatus of claim 2, wherein the fastening module further includes a rotating member from which the support protrusion protrudes, and
the magnetic force unit is installed in the external housing through the rotating member.

5. The apparatus of claim 4, wherein the rotating member includes a rotating ring rotatably mounted on the external housing, and
the magnetic force unit is attached to at least one of the support protrusion and the rotating ring.

6. The apparatus of claim 2, wherein the magnetic force unit includes
a magnet, and
a coating layer covering the magnet to prevent oxidation of the magnet.

7. The apparatus of claim 6, wherein the coating layer includes at least one of nickel, magnesium, titanium, tungsten, and chromium as its coating material.

8. The apparatus of claim 2, wherein the magnetic force unit includes a plurality of magnets forming a circular arrangement around a central axis of the external door.

9. The apparatus of claim 8, wherein the plurality of magnets are classified into a plurality of groups based on a distance by which the magnet is spaced apart from the central axis.

10. A high pressure substrate processing apparatus comprising:
a chamber including a housing, and a door opening and closing the housing;
a fastening module configured to fasten the housing with the door to maintain a process gas injected into the chamber at a pressure higher than an atmospheric pressure; and
a capture module disposed to be adjacent to a contact position between the housing and the door for their fastening, and configured to capture a metal particle,
wherein the capture module includes a magnetic force unit including a magnet adsorbing the metal particle.

11. The apparatus of claim 10, wherein the fastening module includes
a support protrusion connected to the housing, and
a locking protrusion connected to the door, and supported by the support protrusion by transition from a first relationship where the locking protrusion is offset from the support protrusion to a second relationship where the locking protrusion corresponds to the support protrusion, and
the metal particle is formed by contact between the support protrusion and the locking protrusion while the support protrusion performs a relative rotation with respect to the locking protrusion for the transition from the first relationship to the second relationship.

12. The apparatus of claim 10, wherein the magnetic force unit includes the plurality of magnets form a circular arrangement around a central axis of the door.

13. The apparatus of claim 10, wherein the magnetic force unit includes a coating layer coated on the magnet with at least one material selected from nickel, magnesium, titanium, tungsten, and chromium.

14. The apparatus of claim 10, wherein the process gas includes a reaction gas which includes an active gas and a protective gas which is an inert gas,
the housing includes
an inner housing formed to accommodate a substrate to be processed and the reaction gas, and
an external housing accommodating at least a part of the inner housing and coupled to the inner housing to form a closed space for accommodating the protective gas together with the inner housing, and
the door is formed to close the inner housing.

15. The apparatus of claim 14, wherein the fastening module includes
a support protrusion connected to the external housing, and
a locking protrusion connected to the door and transitioned from a first relationship where the locking protrusion is offset from the support protrusion to a second relationship where the locking protrusion is supported by the support protrusion as the door is rotated, and
the magnetic force unit is configured to collect a foreign material formed by contact between the support protrusion and the locking protrusion during the transition from the first relationship to the second relationship.
